# FASCICULE DE BREVET EUROPEEN

(11) **EP 2 912 725 B1**
(45) Date de publication et mention de la délivrance du brevet: **02.12.2020**
(21) Numéro de dépôt: 13783080.8
(22) Date de dépôt: 01.10.2013
(51) Int. Cl.: H01R 12/58, H01R 13/11, H05K 3/40

(54) **CONTACT ÉLECTRIQUE ET CIRCUIT ÉLECTRONIQUE**
ELEKTRISCHER KONTAKT UND ELEKTRONISCHE SCHALTUNG
ELECTRICAL CONTACT AND ELECTRONIC CIRCUIT

(30) Priorité: 25.10.2012 FR 1260163
(43) Date de publication de la demande: 02.09.2015
(73) Titulaire: Valeo Systèmes de Contrôle Moteur, 95892 Cergy - Pontoise (FR)
(72) Inventeur: TRAMET, Guillaume, F-78360 Montesson (FR); MORENO, Jean-Yves, F-49170 La Possoniere (FR)
(74) Mandataire: Argyma
(86) Numéro de dépôt international: PCT/FR2013/052335
(87) Numéro de publication internationale: WO 2014/064356

(56) Documents cités:
- DE-A1- 4 421 731
- US-A- 2 967 285
- US-A- 5 131 853
- US-A- 5 169 322
- US-A- 5 362 244
- US-A- 5 733 133

## Description

La présente invention concerne un contact électrique et un circuit électronique.

Un circuit électronique comporte généralement un support isolant, et des pistes conductrices s'étendant sur le support isolant.

Afin de connecter une broche de connexion d'un composant électronique à l'une des pistes, il est connu de percer le circuit électronique d'une perforation débouchant sur cette piste, et d'utiliser un contact électrique comportant une partie de contact présentant une surface reliée par fusion de matière contre la piste et une pince s'étendant dans la perforation et destinée à recevoir la broche.

Des contacts électriques comportant une pince sont connus de US-5 131 853 et US-2 967 285.

Dans un premier exemple connu, la pince est formée d'un cylindre renfermant un très grand nombre de tiges s'étendant longitudinalement les unes à côtés des autres contre la paroi interne du cylindre. Les tiges sont bombées vers le centre du cylindre et fixées à leur deux extrémités au cylindre. De cette manière, les tiges définissent un rétrécissement dans lequel la broche est destinée à être insérée de manière à écarter les tiges qui, en réaction, vont enserrer la broche et ainsi la maintenir dans le contact.

Un tel contact est compliqué à fabriquer à cause des nombreuses tiges qui doivent être assemblées, et en particulier qui doivent être fixées à leurs deux extrémités.

Dans un autre exemple de contact électrique connu, la pince est formée de deux mors en forme de languette, en vis-à-vis l'un de l'autre. Chaque languette présente une extrémité fixe et une extrémité libre, les extrémités libres étant destinées à enserrer la broche. Un tel contact est plus facile à fabriquer et peut notamment être formé d'une seule feuille métallique découpée et pliée.

Cependant, un tel contact n'offre pas une très bonne préhension de la broche.

Il est donc apparu le besoin d'un nouveau type de contact électrique permettant de résoudre au moins en partie les problèmes indiqués précédemment.

Afin d'atteindre cet objectif, l'invention telle que définie dans les revendications 1 et 2 concerne un contact électrique comportant : une partie de contact présentant une surface destinée à être reliée par fusion de matière à une piste électrique s'étendant sur un support isolant ; et une pince destinée à recevoir une broche d'un composant électrique, de sorte que la broche reçue s'étende selon un axe principal parallèle à une direction haut/bas.

Par exemple, la direction haut/bas correspond à une direction longitudinale du contact électrique.

Selon une caractéristique de l'invention, la pince comporte deux paires de mors, les mors de chaque paire étant disposés en vis-à-vis l'un de l'autre selon une direction de préhension transversale à la direction haut/bas, de manière à enserrer la broche selon ladite direction de préhension, les deux directions de préhension étant différentes l'une de l'autre.

Selon une autre caractéristique de l'invention, les deux directions de préhension sont perpendiculaires.

Selon une autre caractéristique de l'invention, chaque mors a la forme d'une languette présentant un grand côté faisant face à l'axe, et est flexible de manière à être déformé élastiquement par la broche lors de son insertion pour s'écarter de l'axe. Par exemple, lors de son insertion la broche vient en contact avec le grand côté faisant face à l'axe principal.

Selon une autre caractéristique de l'invention, les mors sont de largeur constante.

Selon une autre caractéristique de l'invention, les mors sont de largeur diminuant de l'extrémité fixe à l'extrémité libre.

Selon une autre caractéristique de l'invention, le contact électrique comporte en outre un anneau centré sur l'axe principal, et les mors s'étendent vers le bas en dessous de l'anneau.

Selon une autre caractéristique de l'invention, les extrémités fixes des mors sont attachées à un côté bas de l'anneau.

Selon une autre caractéristique de l'invention, les extrémités fixes des mors sont attachées à un côté haut de l'anneau et les mors sont recourbées pour passer dans l'anneau.

Selon une autre caractéristique de l'invention, la partie de contact comporte le côté bas de l'anneau.

Selon une autre caractéristique de l'invention, la surface de contact s'étend entre les extrémités fixes des mors.

Selon une autre caractéristique de l'invention, la surface de contact s'étend sur tout le tour de l'anneau.

Selon un exemple non revendiqué, la partie de contact comporte au moins une languette de contact comportant une extrémité fixe et une extrémité libre, l'extrémité fixe étant attachée au côté haut de l'anneau, la languette de contact étant recourbée de sorte que l'extrémité libre présente une tranche dirigée vers le bas, et la surface de contact comportant la tranche de l'extrémité libre de la languette de contact.

Selon une autre caractéristique de l'invention, la pince et la partie de contact sont formées d'une seule feuille métallique découpée et pliée.

L'invention concerne en outre un circuit électronique comportant : un contact selon l'invention ; un support isolant ; et une piste électrique s'étendant sur le support isolant ; le support isolant et la piste électrique étant traversés par une perforation, la surface de contact étant reliée par fusion de matière à la piste électrique, et la pince s'étendant dans la perforation.

L'invention concerne aussi un contact électrique comportant :
- une partie de contact présentant une surface destinée à être en contact avec la surface d'un support, et
- une pince destinée à recevoir une broche d'un composant électrique, de sorte que la broche reçue s'étende selon un axe principal parallèle à une direction haut/bas, caractérisé en ce que :
   - la pince comporte au moins deux mors autour de l'axe, destinés à enserrer latéralement la broche, chaque mors présentant une extrémité fixe et une extrémité libre, et en ce que
   - la surface de contact est formée par au moins une tranche destinée à venir s'appuyer sur ladite surface du support, notamment lors de l'assemblage du contact électrique avec le support, plus particulièrement lors du positionnement du contact électrique dans une perforation dudit support.

La surface de contact du contact électrique est par exemple destinée à être reliée par fusion de matière à une piste électrique s'étendant sur un support isolant. La surface de contact du contact électrique est notamment destinée à venir en contact avec une surface externe du support, qui constitue par exemple une face du support.

Dans un exemple non revendiqué, la pince du contact électrique comporte trois mors.

Suivant une variante, la partie de contact comporte au moins une languette dont au moins une partie d'une tranche forme ladite surface de contact et est destinée à venir s'appuyer sur ladite surface du support, notamment lors de l'assemblage du contact électrique avec le support, plus particulièrement lors du positionnement du contact électrique dans une perforation dudit support.

Plus particulièrement, la languette comprend une partie s'étendant suivant l'axe principal parallèle à la direction haut/bas, qui correspond notamment à une direction longitudinale du contact électrique, de sorte qu'une tranche de ladite partie de la languette est destinée venir s'appuyer sur ladite surface du support, notamment lors de l'assemblage du contact électrique avec le support, plus particulièrement lors du positionnement du contact électrique dans une perforation dudit support.

Suivant une variante, le contact électrique comporte un anneau centré sur l'axe principal, et les mors s'étendent vers le bas en dessous de l'anneau.

Dans un exemple particulier, ledit anneau correspond à ladite languette de la partie de contact ayant une forme recourbée de façon à être en forme d'anneau.

Dans un exemple non revendiqué, ladite languette de la partie de contact comporte une extrémité fixe et une extrémité libre, l'extrémité fixe étant attachée au côté haut de l'anneau, la languette de contact étant recourbée de sorte que l'extrémité libre présente une tranche dirigée vers le bas, et la surface de contact comportant la tranche de l'extrémité libre de la languette de contact.

Bien entendu les différentes variantes et formes de réalisation de l'invention peuvent être associées les unes avec les autres selon diverses combinaisons dans la mesure où elles ne sont pas incompatibles ou exclusives les unes des autres. En particulier, le contact électrique décrit en dernier lieu peut comprendre l'une quelconque des caractéristiques décrites auparavant.

Par ailleurs, diverses autres caractéristiques de l'invention ressortent de la description annexée effectuée en référence aux dessins qui illustrent des formes non limitatives de réalisation de l'invention.
- La figure 1 est une vue en coupe d'un circuit électronique mettant en œuvre l'invention.
- La figure 2 est une vue en trois dimensions d'un premier exemple de contact électrique non couvert par l'invention et destiné à être intégré dans le circuit électronique de la figure 1.
- La figure 3 est une vue en trois dimensions d'un deuxième exemple de contact électrique mettant en œuvre l'invention et destiné à être intégré dans le circuit électronique de la figure 1.
- La figure 4 est une vue en trois dimensions d'un troisième exemple de contact électrique mettant en œuvre l'invention et destiné à être intégré dans le circuit électronique de la figure 1.
- La figure 5 est une vue en trois dimensions d'un quatrième exemple de contact électrique mettant en œuvre l'invention et destiné à être intégré dans le circuit électronique de la figure 1.

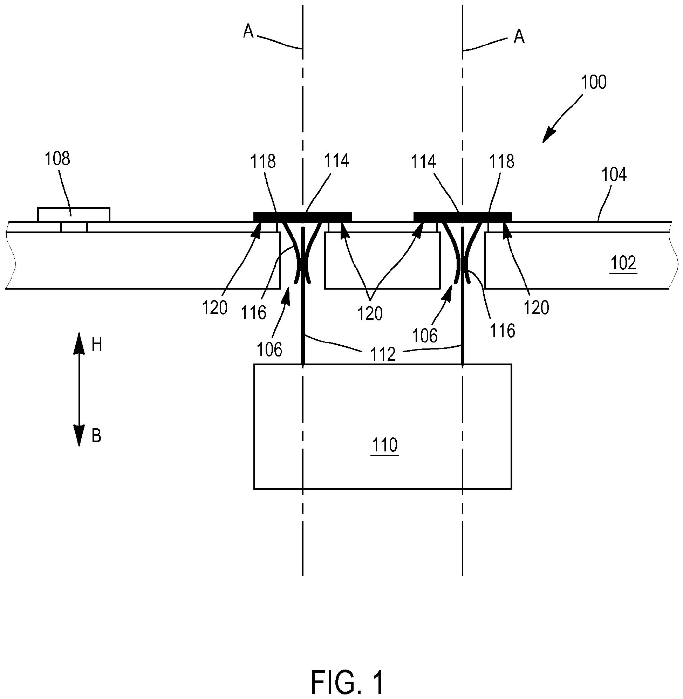

En référence à la figure 1, un circuit électronique mettant en œuvre l'invention, portant la référence générale 100, va être décrit.

Le circuit électronique 100 comporte un support isolant 102 et des pistes conductrices s'étendant sur le support isolant 102, dont la piste 104 représentée sur la figure 1. Le support isolant 102 a la forme d'une plaque perpendiculaire à une direction haut/bas (H et B sur la figure). Cette direction haut/bas servira par la suite pour définir les positions relatives des différents éléments décrits. Cependant, il est évident que cette direction peut être différente de la direction verticale, suivant l'inclinaison réelle du circuit électronique 100. Le circuit électronique 100 est généralement désigné par l'acronyme PCB (de l'anglais « Printed Circuit Board »). Le support isolant 102 est par exemple fait à partir de résine époxy ou de fibre de verre, ou d'une combinaison des deux telle que du matériau connu sous la désignation FR4 ou FR-4.

Le support isolant 102 et la piste 104 sont traversés de perforations 106 dans la direction haut/bas, débouchant sur la piste 104.

Le circuit électronique 100 peut comporter en outre au moins un composant électronique monté en surface, tel que le composant 108 représenté sur la figure 1. Chaque composant monté en surface est par exemple brasé par refusion sur une des pistes conductrices.

Le circuit électronique 100 peut comporter en outre au moins un composant électronique rapporté, tel que le composant 110 représenté sur la figure 1. Le composant 110 est par exemple un transistor bipolaire à grille isolée, généralement désigné par l'acronyme IGBT (de l'anglais « Insulated Gate Bipolar Transistor »), ou bien un connecteur électrique, ou bien encore un bus électrique (appelé « bus-bar » en anglais). Le composant rapporté 110 comporte en particulier des broches de connexion 112, ayant la forme de tiges. Les broches 112 sont respectivement insérées dans les perforations 106. Dans l'exemple décrit, le composant 110 est situé, par rapport au circuit électrique 102, du côté opposé aux pistes conductrices, de sorte que les pattes de connexion 112 présentent des extrémités libres du côté des pistes conductrices.

Le circuit électronique 102 comporte en outre des contacts électriques 114 pour assurer la connexion des pattes de connexion 112 à la piste 104. Chaque contact 114 comporte tout d'abord une pince 116 destinée à recevoir de manière amovible, selon un axe A parallèle à la direction haut/bas, une broche 112 respective, de sorte que la broche 112 reçue s'étende selon l'axe A. Autrement dit, la pince 116 s'étend suivant l'axe A, selon lequel la broche 112 est introduite dans le contact 120. Chaque pince 116 s'étend dans une perforation 106 respective. Chaque contact 114 comporte en outre une partie de contact 118 présentant une surface de contact 120 dirigée vers le bas et destinée à être reliée par fusion de matière à la piste 104.

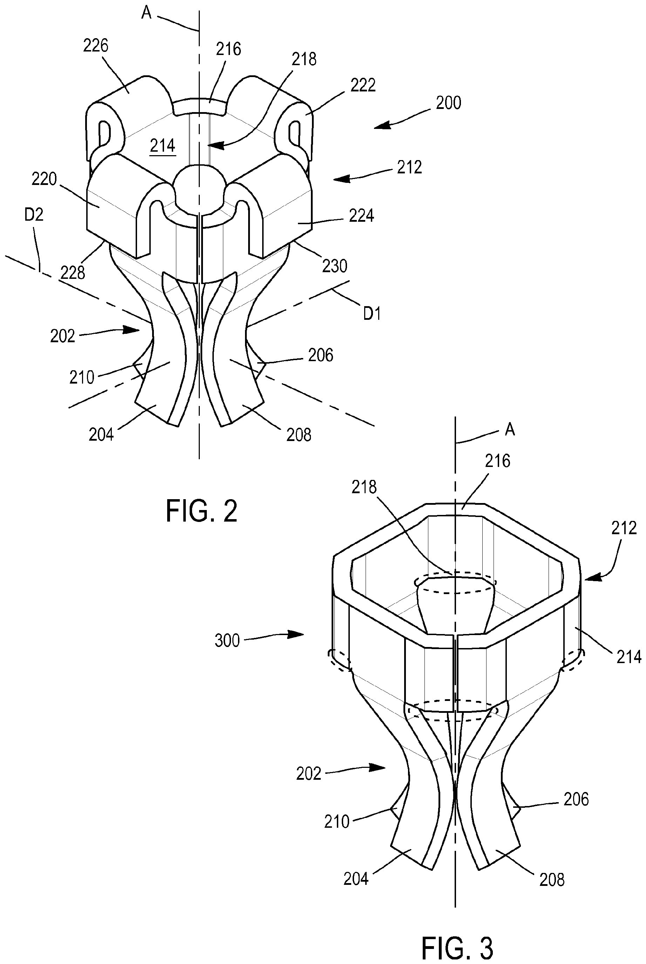

En référence aux figures 2 à 5, quatre exemples de contact électrique destinés à être utilisés en tant que contact électrique 114 vont être décrits. Chacun de ces contacts est formé d'une seule feuille métallique découpée et pliée pour obtenir la forme voulue.

En référence à la figure 2, un premier exemple de contact électrique, désigné par la référence générale 200, va à présent être décrit.

Le contact 200 comporte une pince 202 destinée à recevoir une broche de connexion d'un composant électrique, telle que l'une des broches 112 de la figure 1, de sorte que la broche reçue s'étende selon l'axe A. La pince 202 comporte au moins trois mors autour de l'axe A, entre lesquels la broche est destinée à être enserrée latéralement. Dans l'exemple décrit, la pince 202 comporte deux paires de mors 204 et 206, et 208 et 210. Les mors 204, 206, et 208, 210 de chaque paire sont disposés en vis-à-vis l'un de l'autre selon un axe de préhension transversale D1, respectivement D2, perpendiculaire à l'axe A, de manière à enserrer la broche selon cet axe D1, respectivement D2. Plus précisément, chaque mors 204, 206, 208, 210 présente une extrémité fixe et une extrémité libre destinée à venir au contact de la broche pour l'enserrer. Les deux axes de préhension D1, D2 sont différents l'un de l'autre. Dans l'exemple décrit, les deux axes de préhension D1, D2 sont perpendiculaires l'un à l'autre. Par ailleurs, chaque mors 204, 206, 208, 210 a la forme d'une languette présentant un grand côté faisant face à l'axe A et est flexible de manière à être déformé de manière élastique par la broche lors de son insertion pour s'écarter de l'axe A. Dans l'exemple décrit, les mors 204, 206, 208, 210 sont de largeur constante.

Le contact 200 comporte en outre une partie de contact 212 destinée à être connectée à une piste, telle que la piste 104 de la figure 1. Dans l'exemple décrit, la partie de contact 212 comporte un anneau 214 centré sur l'axe A et présentant un côté haut 216 et un côté bas 218. Dans l'exemple décrit, l'anneau 214 est de forme cylindrique, et le côté haut est formé de la tranche haute de l'anneau 214, tandis que le côté bas est formée de la tranche basse de l'anneau 214. Les extrémités fixes des mors 204, 206, 208, 210 sont attachées au côté bas 218 de l'anneau 214 et s'étendent vers le bas en dessous de l'anneau 214. Par ailleurs, les extrémités libres des mors 204, 206, 208, 210 sont recourbées à l'opposé de l'axe A, c'est-à-dire de façon à s'éloigner de l'axe A, pour faciliter l'insertion par le bas de la broche.

La partie de contact 212 comporte quatre languettes de contact 220, 222, 224, 226 comportant chacune une extrémité fixe et une extrémité libre. L'extrémité fixe étant attachée au côté haut 216 de l'anneau 214. Chaque languette de contact 220, 222, 224, 226 est recourbée de sorte que son extrémité libre présente une tranche 228, 230 dirigée vers le bas (seules les tranches 228, 230 des deux languettes de contact 220, 224 sont visibles sur la figure 2). Les quatre tranches 228, 230 forment une surface de contact destinée à être relié par fusion de matière à une piste, telle que la piste 104 de la figure 1.

En référence à la figure 3, un deuxième exemple de contact électrique, désigné par la référence générale 300, va à présent être décrit. Les éléments identiques à ceux du contact 200 de la figure 2 ne sont pas décrits à nouveau et portent les mêmes références.

Le contact 300 est identique au contact 200, si ce n'est qu'il ne comporte pas les languettes de contact 220, 224, 226, 228.

Ainsi, la surface de contact est cette fois formée par les quatre parties du côté bas 218 de l'anneau 214 s'étendant entre les mors 204, 206, 208, 210. La surface de contact est indiquée par des pointillés sur la figure 3.

La pince 202 du contact 300 est destinée à être insérée dans une perforation carrée, de sorte que les quatre parties du côté bas 218 de l'anneau 214 reposent respectivement sur les quatre côtés du carré.

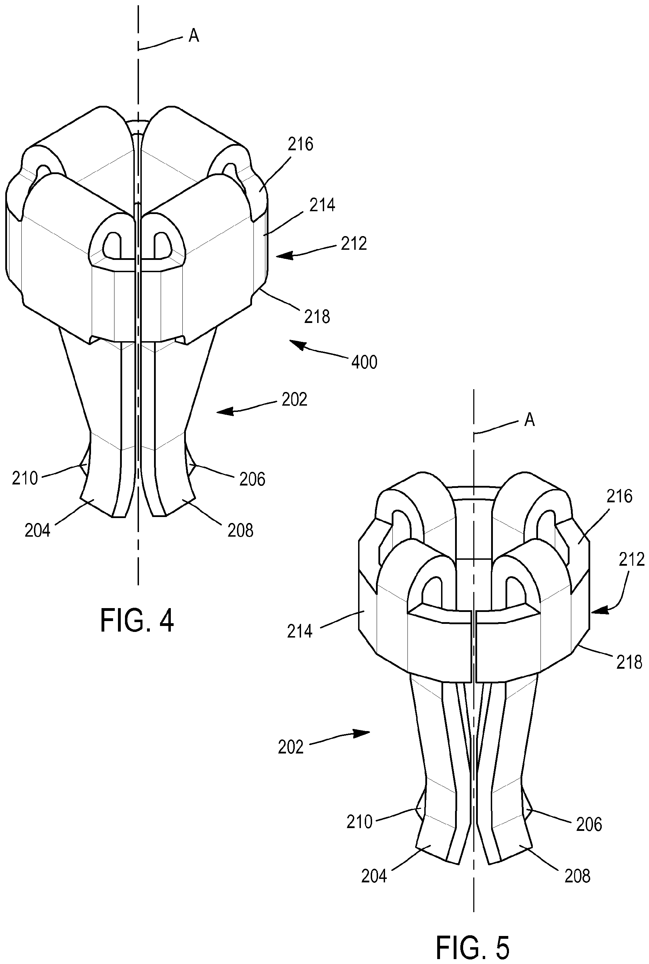

En référence à la figure 4, un troisième exemple de contact électrique, désigné par la référence générale 400, va à présent être décrit. Les éléments identiques à ceux du contact 300 de la figure 3 ne sont pas décrits à nouveau et portent les mêmes références.

Le contact 400 est identique au contact 300, si ce n'est que les extrémité fixes des mors 204, 206, 208, 210 sont attachées au côté haut 216 de l'anneau 214, et que les mors 204, 206, 208, 210 sont recourbées pour passer dans l'anneau 214 et s'étendre vers le bas, en dessous de l'anneau 214. En outre, les mors 204, 206, 208, 210 présentent une largeur diminuant de l'extrémité fixe à l'extrémité libre. Ainsi, les mors 204, 206, 208, 210 présentent une largeur importante à leur extrémité fixe, ce qui améliore leur solidité. Dans ce cas, l'anneau 214 présente une forme générale se rapprochant de celle d'un carré.

Dans le contact 400, comme les mors 204, 206, 208 210 s'étendent depuis le côté haut 216 de l'anneau, cela permet à la surface de contact, formée par le côté bas 218 de l'anneau 214, de s'étendre sur tout le tour de l'anneau 214.

En référence à la figure 5, un quatrième exemple de contact électrique, désigné par la référence générale 500, va à présent être décrit. Les éléments identiques à ceux du contact 400 de la figure 4 ne sont pas décrits à nouveau et portent les mêmes références.

Le contact 500 est identique au contact 400 si ce n'est que les mors 204, 206, 208, 210 en forme de languette ont une largeur constante. Cela permet de donner une forme circulaire à l'anneau 214.

Bien entendu, l'invention n'est pas limitée aux exemples décrits. Par exemple sur la figure 1, le composant 110 pourrait être situé, par rapport au circuit électrique 102, du côté comportant les pistes conductrices, de sorte que les pattes de connexion 112 présentent des extrémités libres du côté opposé aux pistes conductrices.

## Revendications

1. Contact électrique (300 ; 400 ; 500) comportant :
- une partie de contact (212) présentant une surface de contact (218) destinée à être en contact avec la surface d'un support (102), et
- une pince (202) destinée à recevoir une broche (112) d'un composant électrique (110), de sorte que la broche (112) reçue s'étende selon un axe principal (A) parallèle à une direction haut/bas, ladite pince (202) comprenant au moins deux mors (204, 206, 208, 210) autour de l'axe (A), destinés à enserrer latéralement la broche (112), chaque mors (204, 206, 208, 210) présentant une extrémité fixe et une extrémité libre,
la partie de contact (212) comporte un anneau (214) correspondant à une languette ayant une forme recourbée de façon à être en forme d'anneau, au moins une partie d'une tranche dudit anneau (214) formant ladite surface de contact (218) et étant destinée à venir s'appuyer sur ladite surface du support (102) et à être reliée par fusion de matière à une piste électrique (104) s'étendant sur le support (102), **caractérisé en ce que**, ledit anneau (214) étant centré sur l'axe principal (A), les extrémités fixes des mors (204, 206, 208, 210) sont attachées à un côté haut (216) de l'anneau (214), et lesdits mors (204, 206, 208, 210) sont recourbés pour passer dans l'anneau et s'étendre vers le bas en dessous de l'anneau (214).

2. Contact électrique (300 ; 400 ; 500) comportant :
- une partie de contact (212) présentant une surface de contact (218) destinée à être en contact avec la surface d'un support (102), et
- une pince (202) destinée à recevoir une broche (112) d'un composant électrique (110), de sorte que la broche (112) reçue s'étende selon un axe principal (A) parallèle à une direction haut/bas, ladite pince (202) comprenant deux paires de mors (204, 206, 208, 210) autour de l'axe (A), destinés à enserrer latéralement la broche (112), chaque mors (204, 206, 208, 210) présentant une extrémité fixe et une extrémité libre,
la partie de contact (212) comportant un anneau (214) correspondant à une languette ayant une forme recourbée de façon à être en forme d'anneau, au moins une partie d'une tranche dudit anneau (214) formant ladite surface de contact (218) et étant destinée à venir s'appuyer sur ladite surface du support (102) et à être reliée par fusion de matière à une piste électrique (104) s'étendant sur le support (102),
ledit anneau (214) étant centré sur l'axe principal (A),
les extrémités fixes des deux paires de mors (204, 206, 208, 210) étant attachées au côté bas de l'anneau (214) et s'étendant vers le bas en dessous de l'anneau (214),
la surface de contact (218) étant formée des quatre parties du côté bas de l'anneau (214) s'étendant entre les extrémités fixes des mors (204, 206, 208, 210), **caractérisé en ce que**
la pince (202) du contact est destinée à être insérée dans une perforation carrée de sorte que les quatre parties du côté bas de l'anneau (214) soient adaptées à être reposées respectivement sur les quatre côtés d'un tel carré.

3. Contact électrique (300 ; 400 ; 500) selon la revendication 1 dans lequel la pince (202) comporte deux paires de mors (204, 206, 208, 210) ou selon la revendication 2, les mors de chaque
paire étant disposés en vis-à-vis l'un de l'autre selon une direction de préhension transversale (D1, D2) à la direction haut/bas, de manière à enserrer la broche selon ladite direction de préhension, les deux directions de préhension (D1, D2) étant différentes l'une de l'autre.

4. Contact électrique (300 ; 400 ; 500) selon la revendication 3, dans lequel les deux directions de préhension (D1, D2) sont perpendiculaires.

5. Contact électrique (300 ; 400 ; 500) selon l'une quelconque des revendications 1 à 4, dans lequel chaque mors (204, 206, 208, 210) a la forme d'une languette présentant un grand côté faisant face à l'axe (A), et est flexible de manière à être déformé élastiquement par la broche lors de son insertion pour s'écarter de l'axe (A).

6. Contact électrique (300 ; 500) selon l'une quelconque des revendications 1 à 5, dans lequel les mors (204, 206, 208, 210) sont de largeur constante.

7. Contact électrique (400) selon l'une quelconque des revendications 1 à 5, dans lequel les mors (204, 206, 208, 210) sont de largeur diminuant de l'extrémité fixe à l'extrémité libre.

8. Contact électrique (400 ; 500) selon la revendication 1, dans lequel la surface de contact s'étend sur tout le tour de l'anneau (214).

9. Contact électrique (300 ; 400 ; 500) selon l'une quelconque des revendications précédentes, dans lequel la pince (202) et la partie de contact (212) sont formées d'une seule feuille métallique découpée et pliée.

10. Circuit électronique (100) comportant :
- un contact (300 ; 400 ; 500) selon l'une quelconque des revendications 1 à 9,
- un support isolant (102), et
- une piste électrique (104) s'étendant sur le support isolant (102),
le support isolant (102) et la piste électrique (104) étant traversés par une perforation (106), la surface de contact (218) étant reliée par fusion de matière à la piste électrique (104), et la pince (202) s'étendant dans la perforation (106).

## Patentansprüche

1. Elektrischer Kontakt (300; 400; 500), aufweisend:
- einen Kontaktteil (212), der eine Kontaktfläche (218) aufweist, die bestimmt ist, mit der Fläche einer Unterlage (102) im Kontakt zu sein, und
- eine Klemme (202), die bestimmt ist, einen Stift (112) eines elektrischen Bauteils (110) derart aufzunehmen, dass sich der aufgenommene Stift (112) gemäß einer Hauptachse (A) erstreckt, die parallel zu einer Richtung oben/unten ist, wobei die Klemme (202) mindestens zwei Backen (204, 206, 208, 210) um die Achse (A) umfasst, die bestimmt sind, den Stift (112) seitlich einzuklemmen, wobei jede Backe (204, 206, 208, 210) ein festes Ende und ein freies Ende aufweist,
wobei der Kontaktteil (212) einen Ring (214) aufweist, der einer Zunge mit einer derart gekrümmten Form entspricht, dass eine Ringform vorliegt, wobei mindestens ein Teil einer Kante des Rings (214) die Kontaktfläche (218) bildet und bestimmt ist, sich auf der Fläche der Unterlage (102) abzustützen und durch Materialverschmelzung mit einer elektrischen Leiterbahn (104) verbunden zu sein, die sich auf der Unterlage (102) erstreckt, **dadurch gekennzeichnet, dass** der Ring (214) auf der Hauptachse (A) zentriert ist, wobei die festen Enden der Backen (204, 206, 208, 210) an einer hohen Seite (216) des Rings (214) angebracht sind und die Backen (204, 206, 208, 210) gekrümmt sind, um in den Ring zu reichen und sich nach unten unterhalb des Rings (214) zu erstrecken.

2. Elektrischer Kontakt (300; 400; 500), aufweisend:
- einen Kontaktteil (212), der eine Kontaktfläche (218) aufweist, die bestimmt ist, mit der Fläche einer Unterlage (102) im Kontakt zu sein, und
- eine Klemme (202), die bestimmt ist, einen Stift (112) eines elektrischen Bauteils (110) derart aufzunehmen, dass sich der aufgenommene Stift (112) gemäß einer Hauptachse (A) erstreckt, die parallel zu einer Richtung oben/unten ist, wobei die Klemme (202) zwei Paar Backen (204, 206, 208, 210) um die Achse (A) umfasst, die bestimmt sind, den Stift (112) seitlich einzuklemmen, wobei jede Backe (204, 206, 208, 210) ein festes Ende und ein freies Ende aufweist,
wobei der Kontaktteil (212) einen Ring (214) aufweist, der einer Zunge mit einer derart gekrümmten Form entspricht, dass eine Ringform vorliegt, wobei mindestens ein Teil einer Kante des Rings (214) die Kontaktfläche (218) bildet und bestimmt ist, sich auf der Fläche der Unterlage (102) abzustützen und durch Materialverschmelzung mit einer elektrischen Leiterbahn (104) verbunden zu sein, die sich auf der Unterlage (102) erstreckt, wobei der Ring (214) auf der Hauptachse (A) zentriert ist, wobei die festen Enden der zwei Paar Backen (204, 206, 208, 210) an der tiefen Seite (216) des Rings (214) angebracht sind und sich nach unten unterhalb des Rings (214) erstrecken, wobei die Kontaktfläche (218) von den vier Teilen der tiefen Seite des Rings (214) gebildet ist, die sich zwischen den festen Enden der Backen (204, 206, 208, 210) erstreckt, **dadurch gekennzeichnet, dass** die Klemme (202) des Kontakts bestimmt ist, in eine quadratische Perforation derart eingesetzt zu sein, dass die vier Teile der tiefen Seite des Rings (214) angepasst sind, um jeweils auf den vier Seiten eines derartigen Quadrats zu ruhen.

3. Elektrischer Kontakt (300; 400; 500) nach Anspruch 1, wobei die Klemme (202) zwei Paar Backen (204, 206, 208, 210) aufweist, oder nach Anspruch 2, wobei die Backen jedes Paares gemäß einer zu der Richtung oben/unten transversalen Greifrichtung (D1, D2) einander gegenüber derart angeordnet sind, dass der Stift gemäß der Greifrichtung eingeklemmt wird, wobei die zwei Greifrichtungen (D1, D2) voneinander unterschiedlich sind.

4. Elektrischer Kontakt (300; 400; 500) nach Anspruch 3, wobei die zwei Greifrichtungen (D1, D2) senkrecht sind.

5. Elektrischer Kontakt (300; 400; 500) nach einem der Ansprüche 1 bis 4, wobei jede Backe (204, 206, 208, 210) die Form einer Zunge hat, die eine große Seite aufweist, die der Achse (A) gegenüberliegt und derart flexibel ist, dass sie vom Stift bei seinem Einsetzen elastisch verformt wird, um sich von der Achse (A) abzuspreizen.

6. Elektrischer Kontakt (300; 500) nach einem der Ansprüche 1 bis 5, wobei die Backen (204, 206, 208, 210) eine konstante Breite haben.

7. Elektrischer Kontakt (400) nach einem der Ansprüche 1 bis 5, wobei die Backen (204, 206, 208, 210) eine Breite haben, die vom festen Ende zum freien Ende abnimmt.

8. Elektrischer Kontakt (400; 500) nach Anspruch 1, wobei sich die Kontaktfläche über den gesamten Umfang des Rings (214) erstreckt.

9. Elektrischer Kontakt (300; 400; 500) nach einem der vorangehenden Ansprüche, wobei die Klemme (202) und der Kontaktteil (212) aus einem einzigen geschnittenen und gefalteten Metallbogen gebildet sind.

10. Elektronische Schaltung (100), aufweisend:
- einen Kontakt (300; 400; 500) nach einem der Ansprüche 1 bis 9,
- eine isolierende Unterlage (102), und
- eine elektrische Leiterbahn (104), die sich auf der isolierenden Unterlage (102) erstreckt,
wobei die isolierende Unterlage (102) und die elektrische Leiterbahn (104) von einer Perforation (106) durchquert werden, wobei die Kontaktfläche (218) durch Materialverschmelzung mit der elektrischen Leiterbahn (104) verbunden ist und sich die Klemme (202) in die Perforation (106) erstreckt.

## Claims

1. Electrical contact (300; 400; 500), comprising:
- a contact part (212) having a contact surface (218) configured to be in contact with the surface of a support (102), and
- a clip (202) configured to receive a pin (112) of an electrical component (110), so that the received pin (112) extends along a main axis (A) parallel to an up/down direction, said clip (202) comprising at least two jaws (204, 206, 208, 210) around the axis (A), which are configured to laterally grip the pin (112), each jaw (204, 206, 208, 210) having a fixed end and a free end,
the contact part (212) comprises a ring (214) corresponding to a tongue having a curved shape so as to have the shape of a ring, at least one part of an edge of said ring (214) forming said contact surface (218) and being configured to bear on said support surface (102) and to be connected by material fusion to an electrical track (104) extending over the support (102), **characterized in that**, said ring (214) being centered on the main axis (A), the fixed ends of the jaws (204, 206, 208, 210) are attached to an upper side (216) of the ring (214), and said jaws (204, 206, 208, 210) are curved in order to pass through the ring and extend downward below the ring (214).

2. Electrical contact (300; 400; 500), comprising:
- a contact part (212) having a contact surface (218) configured to be in contact with a surface of a support (102), and
- a clip (202) configured to receive a pin (112) of an electrical component (110), so that the received pin (112) extends along a main axis (A) parallel to an up/down direction, said clip (202) comprising at least two jaws (204, 206, 208, 210) around the axis (A), configured to laterally grip the pin (112), each jaw (204, 206, 208, 210) having a fixed end and a free end,
the contact part (212) comprising a ring (214) corresponding to a tongue having a curved shape so as to have the shape of a ring, at least one part of an edge of said ring (214) forming said contact surface (218) and being configured to bear on said support surface (102) and to be connected by material fusion to an electrical track (104) extending over the support (102),
said ring (214) being centered on the main axis (A), the fixed ends of the two pairs of jaws (204, 206, 208, 210) being attached to the lower side of the ring (214) and extending downward below the ring (214), th
e contact surface (218) being formed from the four parts of the lower side of the ring (214) extending between the fixed ends of the jaws (204, 206, 208, 210), **characterized in that** the clip (202) of the contact is configured to be inserted into a square perforation in such a way that the four parts of the lower side of the ring (214) are adapted to be positioned respectively on the four sides of such a square.

3. Electrical contact (300; 400; 500) as claimed in claim 1, wherein the clip (202) comprises two pairs of jaws (204, 206, 208, 210) or as claimed in claim 2, the jaws of each pair being arranged facing one another in an engagement direction (D1, D2) transverse to the up/down direction, so as to grip the pin along said engagement direction, the two engagement directions (D1, D2) being different to one another.

4. Electrical contact (300; 400; 500) as claimed in claim 3, wherein the two engagement directions (D1, D2) are perpendicular.

5. The electrical contact (300; 400; 500) as claimed in any one of claims 1 to 4, wherein each jaw (204, 206, 208, 210) has the shape of a tongue having a large side facing toward the axis (A) and is flexible so as to be elastically deformed by the pin in order to move away from the axis (A) when the pin is inserted.

6. Electrical contact (300; 500) as claimed in any one of claims 1 to 5, wherein the jaws (204, 206, 208, 210) are of constant width.

7. Electrical contact (400) as claimed in any one of claims 1 to 5, wherein the jaws (204, 206, 208, 210) have a width decreasing from the fixed end to the free end.

8. Electrical contact (400; 500) as claimed in claim 1, wherein the contact surface extends all around the ring (214).

9. Electrical contact (300; 400; 500) as claimed in any one of the preceding claims, wherein the clip (202) and the contact part (212) are formed from a single cut and folded metal sheet.

10. Electronic circuit (100), comprising:
- a contact (300; 400; 500) as claimed in any one of claims 1 to 9,
- an insulating support (102), and
- an electrical track (104) extending over the insulating support (102),
the insulating support (102) and the electrical track (104) being pierced by a perforation (106), the contact surface (218) being connected by material fusion to the electrical track (104), and the clip (202) extending through the perforation (106).
